# EUROPÄISCHE PATENTSCHRIFT

(11) **EP 0 832 547 B1**
(45) Veröffentlichungstag und Bekanntmachung des Hinweises auf die Patenterteilung: **20.01.1999**
(21) Anmeldenummer: 95928433.2
(22) Anmeldetag: 16.08.1995
(51) Int. Cl.: H05K 7/14

(54) **FRONTSYSTEM FÜR EINE FLACHBAUGRUPPE MIT AKTIV-PASSIV-SCHALTUNG**
FRONT PANEL SYSTEM FOR A PRINTED CIRCUIT CARD WITH ACTIVE/PASSIVE SWITCHING
SYSTEME DE PANNEAU AVANT POUR CARTES A CIRCUITS IMPRIMES A COMMUTATION ACTIVE/PASSIVE

(30) Priorität: 12.06.1995 DE 29509603 U
(43) Veröffentlichungstag der Anmeldung: 01.04.1998
(73) Patentinhaber: SIEMENS AKTIENGESELLSCHAFT, 80333 München (DE)
(72) Erfinder: BILLENSTEIN, Ernst, D-91593 Burgbernheim (DE); KÖRBER, Werner, D-91282 Betzenstein (DE); KURRER, Siegfried, D-90449 Nürnberg (DE); SCHAFFER, Kurt-Michael, D-90542 Eckental (DE)
(86) Internationale Anmeldenummer: DE9501080
(87) Internationale Veröffentlichungsnummer: WO9642187

(56) Entgegenhaltungen:
- EP-A- 0 313 270
- EP-A- 0 369 025
- EP-A- 0 534 674
- DE-A- 4 105 948

## Beschreibung

Aus der EP 0 304 772 B1 ist ein Frontstecksystem mit einer nacheilenden Endkontaktvorrichtung bekannt. Dabei ist ein Frontsteckverbinder auf ein an der Stirnseite einer Flachbaugruppe befindliches Frontelement aufsteckbar. Dies erfolgt mittels einer Drehbewegung, indem der Frontsteckverbinder in ein Drehlager an einem Ende des Frontelementes einhängbar ist. Am anderen Ende von Frontelement und Frontsteckverbinder befindet sich eine Endkontaktvorrichtung, welche erst dann in Eingriff kommt, nachdem aufgrund einer Bedienung einer Verschlußvorrichtung der Frontsteckverbinder vollständig auf dem Frontelement aufgesteckt ist. Als Verschlußvorrichtung dient bevorzugt eine ebenfalls in das andere Ende des Frontsteckverbinders eingesetzte Schraube, so daß die Arbeitskontakte der Endkontaktvorrichtung erst dann in Eingriff kommen, wenn die Schraube vollständig in ein gegenüber im Frontelement befindliches Gewinde eingeschraubt ist und hiermit das vollständige Aufstecken des Frontelementes bewirkt wurde. Hiermit kann sichergestellt werden, daß die über das Frontelement und den Frontsteckverbinder geleiteten elektrischen Signale gleichzeitig erst dann freigegeben werden, wenn alle Kontakte zwischen Frontelement und Frontsteckverbinder geschlossen sind, bzw. der gestoppt wird, bevor einer der Kontakte beim Abschwenken des Frontsteckverbinders unterbrochen wird.

Es ist zum Teil notwendig, auch bei Flachbaugruppen, welche mittels einer z.B. aus der EP 0 194 515 B1 bekannten Steck- und Ziehhilfe in den Steckplatz eines Baugruppenträgers eingehebelt bzw. ausgehoben werden können, eine geordnete Freigabe bzw. Unterbrechung des gesamten Signalaustausches über deren rückseitigen Steckverbinder zu einer Rückwandleiterplatte des Baugruppenträgers und einem dort befindlichen Datenbus zu bewirken. So soll z.B. zu Beginn der Aushebelung einer Flachbaugruppe eine komplette Unterbrechung von deren Signalaustausch bewirkt werden können, bevor einer der Kontakte zwischen Steckverbinder und Rückwandleiterplatte getrennt wird, während andere Kontakte noch nicht unterbrochen sind.

Zur Lösung dieses Problems wird in der Druckschrift Honeywell Outline, Sensorik und Automation, Jahrgang 9, Heft 1, Seiten 10, 12 in dem Artikel "Leiterplattenausbau ohne Systemunterbrechung mit Honeywell Schaltern und Sensoren' vorgeschlagen, an der Kante einer Leiterplatte entweder auf deren Ober- oder Unterseite z.B. einen Schalter anzubringen und über entsprechende Leiterbahnen z.B. mit der Hauptstromversorgung zu verbinden. Auf den Schalter wirkt ein Verriegelungsmechanismus ein, welcher die Leiterplatte in ihrer Position im Baugruppenträger fixiert. Im verriegelten Zustand liegt der Riegel des Verriegelungsmechanismus an der den Schalter tragenden Kante der Leiterplatte an und bewirkt eine Betätigung des Schalters und somit eine elektrische Aktivierung der Leiterplatte. Wird dagegen der Riegel von der Kante abgeschwenkt, so wird der Schalter unterbrochen und die Leiterplatte elektrisch inaktiv geschaltet. An Stelle des Schalters kann auch ein Infrarotbauteil eingesetzt werden.

Ein wesentliches Problem dieser Vorrichtung wird darin gesehen, daß eine präzise Positionierung des Schalters am Leiterplattenrand außerordentlich schwierig ist. Wird der Schalter z.B. mit entsprechenden Leiterbahnen auf der Leiterplattenoberfläche verlötet, so ist es bedingt durch den Lötprozeß nur sehr schwer möglich sicherzustellen, daß der Schalthebel insbesondere eines Miniaturschalters so genau plaziert werden kann, daß dieser bei Anliegen des Riegels an der Kante der Leiterplatte ordnungsgemäß betätigt wird.

Der Erfindung liegt somit die Aufgabe zugrunde ein Frontsystem für eine Flachbaugruppe anzugeben, welches in einer präzisen und dauerhaften Weise mit einer elektrischen Aktiv-Passiv-Schaltung für die Leiterplatte versehen ist.

Die Aufgabe wird gelöst mit der im Anspruch 1 angegebenen Vorrichtung. Weitere, vorteilhafte Ausführungsformen der Erfindung sind in den Unteransprüchen angegeben.

Die Erfindung wird mit den in den nachfolgend kurz angeführten Figuren dargestellten Beispielen weiter erläutert, Dabei zeigt
- Fig.1.: eine perspektivische Seitenansicht auf die untere Querschiene eines Baugruppenträgers und ein gemäß der Erfindung gestaltetes unteres Endstück für die Frontplatte einer Laiterplatte mit Hebel-Ziehgriff,
- Fig.2.: eine Schnittdarstellung durch den in Figur 1 dargestellten Bereich mit einem Schnappschalter als integriertes Schaltelement,
- Fig.3.: eine Schnittdarstellung durch den in Figur 1 dargestellten Bereich mit einem Halleffektsensor und einem Magneten als integriertes Schaltelement, und
- Fig.4.: eine Schnittdarstellung durch den in Figur 1 dargestellten Bereich mit einer Lichtschranke als integriertes Schaltelement.

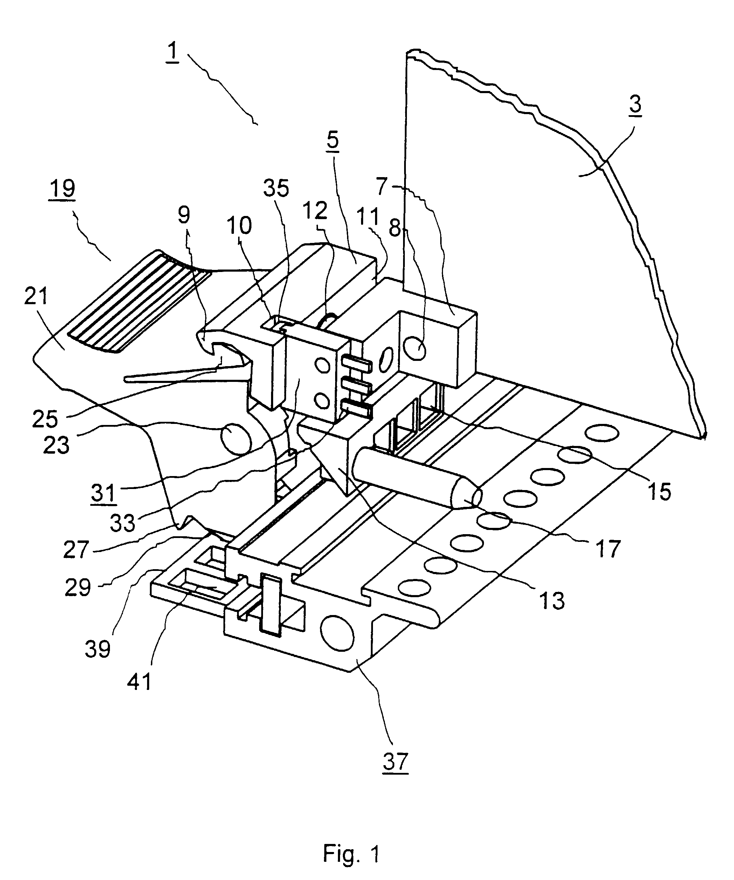

Figur 1 zeigt in einer perspektivischen Seitenansicht den unteren, vorderen Endbereich 1 eines gemäß der Erfindung gestalteten Frontsystems einer Flachbaugruppe 3 welche in Form von deren unterem, vorderen Eckbereich ausschnittsweise dargestellt ist. Der untere Endbereich ruht dabei auf der unteren Querschiene 37 eines Baugruppenträgers und weist dabei als Hauptkomponenten einen unteren Hebelziehgriff 19, ein unteres Endstück 5 und eine aus Gründen der Übersichtlichkeit nicht dargestellte Frontplatte auf. Dem unteren Endstuck 5 kommt dabei eine zentrale Haltefunktion zu, da es zum einen als Träger für den insbesondere über einen Bohrungszapfen 23 drehbar gelagerten Hebelziehgriff 19 dient. Andererseits kann es auch zur Halterung des unteren Endes einer Frontplatte dienen, welche hierzu vorteilhaft in eine Nut 11 eingeschoben und über eine in eine Bohrung 12 eingreifende Schraube gehalten wird. Die Verbindung zwischen dem unteren Endstück 5 und der vorderen, unteren Ecke der Flachbaugruppe erfolgt bevorzugt über einen Halteblock 7 mittels einer in eine Bohrung 8 eingreifenden Schraube.

Schließlich können weitere Komponenten am Endstück angebracht sein. So enthält das in Figur 1 dargestellte Endstück einen Kodierblock 13, in den Kodierkammern zum Einsetzen von Kodierstiften eingebracht sind. Diese können auf gegenüberliegend am unteren Querträger 37 angebrachten Kodierkammern eingreifen, welche mit komplementär kodierten Kodierstiften bestückt sind. Hiermit kann sichergestellt werden, daß nur eine bestimmte, ausgewählte Flachbaugruppe in einem Steckplatz eines Baugruppenträgers positionierbar ist. Schließlich ist noch ein Führungsstift 17 vorhanden, welcher nach Eingriff in eine gegenüberliegende Führungsbohrung ein verkantfreies, ordnungsgemäßes Einschieben der Flachbaugruppe gewährleistet.

Zum Ein- bzw. Aushebeln der Flachbaugruppe 3 in den bzw. aus dem entsprechenden Steckplatz dient ein unterer Hebelziehgriff 19, welcher durch Betätigung des Griffteils 21 bedient werden kann. Beim Aushebeln muß der Griff nach unten gedrückt werden, so daß sich mindestens eine auf der Unterseite vorspringende Aushebelnase 27 an einer Stirnkante 39 der unteren Querschiene 37 abstützen kann. Umgekehrt muß beim Einhebeln der Griff nach oben gedrückt werden, so daß sich mindestens eine ebenfalls auf der Unterseite vorspringende Einhebelkante 29 im Inneren von ebenfalls im Bereich der Stirnkante 39 der unteren Querschiene 37 befindliche mindestens eine Eingriffsmulde 41 abstützen kann. Üblicherweise sind am Endstück 5 noch Mittel vorhanden, über die der Hebelziehgriff 19 bei Erreichen des in den Baugruppenträger vollständig eingeschobenen Zustands der Flachbaugruppe 3 in der entsprechenden Position fixiert wird. Dieser Zustand ist in Figur 1 dargestellt. Vorteilhaft weist der Hebelziehgriff 19 hierzu auf seiner Oberseite eine auf das Endstück 5 gerichtete, federnde und nach oben stehende Rastnase 25 auf, welche eine auf den Hebelziehgriff 19 gerichtete und nach unten abgehende Rastkante 9 am unteren Endstück 5 hintergreift.

In der gleichen Weise ist auch an dem in Figur 1 nicht dargestellten vorderen, oberen Eckbereich der Flachbaugruppe eine entsprechende Anordnung aus einem oberen Endstück mit einem daran drehbar gelagerten oberen Hebelziehgriff angebracht. Dieser greift dann zum Ein- und Aushebeln in eine entsprechende obere Querschiene eines Baugruppenträgers ein.

Erfindungsgemäß ist nun im unteren oder oberen Endstück ein Schaltelement derart integriert, daß dieses durch den entsprechenden Hebelziehgriff bei Vorliegen von dessen fixierter Position betätigt wird. Es ist hiermit möglich, die Flachbaugruppe elektrische freizuschalten, z.B. durch Aktivierung von deren Stromversorgung. Umgekehrt kann die Flachbaugruppe elektrisch passiv geschaltet werden, in dem im Moment einer Aushebelung der Flachbaugruppe der Eingriff des Hebelziehgriffes auf das in das Endstück integrierte Schaltelement endet, und durch diese Freigabe des Schaltelements z.B. die elektrische Stromversorgung der Flachbaugruppe wieder passiviert wird.

In Figur 1 ist beispielhaft ein in das untere Endstück 5 integriertes Schaltelement 31 dargestellt. Dieses ist in einem bis in den Bereich der Rastkante 9 des Endstückes 5 reichenden Aufnahmeschlitz 10 gelagert. Ein in Figur 1 verdecktes, nicht sichtbares Schaltteil des Schaltelementes, z.B. ein Schalthebel ragt somit in den Bereich unterhalb der nach unten abgehenden Rastkante 9 hinein, und wird bei Erreichen des fixierten Zustandes des Hebelziehgriffes durch dessen auftreffende Hinterseite betätigt. Im Beispiel der Figur 1 kann diese Betätigung z.B. durch die dem unteren Endstück 5 zugewandte Stirnseite der Rastnase 25 erfolgen. Vorteilhaft ist das integrierte Schaltelement 31 über eine an Anschlußkontakten 33 anbringbare Kabel- oder Kabelsteckverbindung mit der Flachbaugruppe 3 elektrisch verbindbar. Es sind aber auch andersartige Verbindungen möglich. So können z.B. die Anschlußkontakte drahtförmig bis auf die Oberfläche der Flachbaugruppe 3 heruntergezogen und in dort vorhandenen Bohrungen verlötet werden.

Die erfindungsgemäße Aktiv-Passiv-Schaltung hat den Vorteil, daß das Schaltelement 31 durch dessen Integration in ein unteres oder oberes Endstück des Frontsystems einer Flachbaugruppe sehr exakt in eine genau definierbare Position gebracht werden kann. Es ist somit auch dann möglich, das Schaltelement dauerhaft sicher und verschleißfrei über den Hebelziehgriff zu betätigen, wenn die Schaltmittel des Schaltelementes nur einen sehr geringen schaltweg aufweisen. Da die Aktiv-Passiv-Schaltfunktion vollständig in das Frontsystem integriert ist, unterliegen Anwender des Frontsystems keinerlei Einschränkungen bezüglich der Positionierung von Bauelementen auf einer mit einem erfindungsgemäßen Frontsystern ausgestatteten Flachbaugruppe. Insbesondere sind dort keine maßlich genauen Positionsfestlegungen bezüglich elektrischer Anschlüsse für das Schaltelement notwendig.

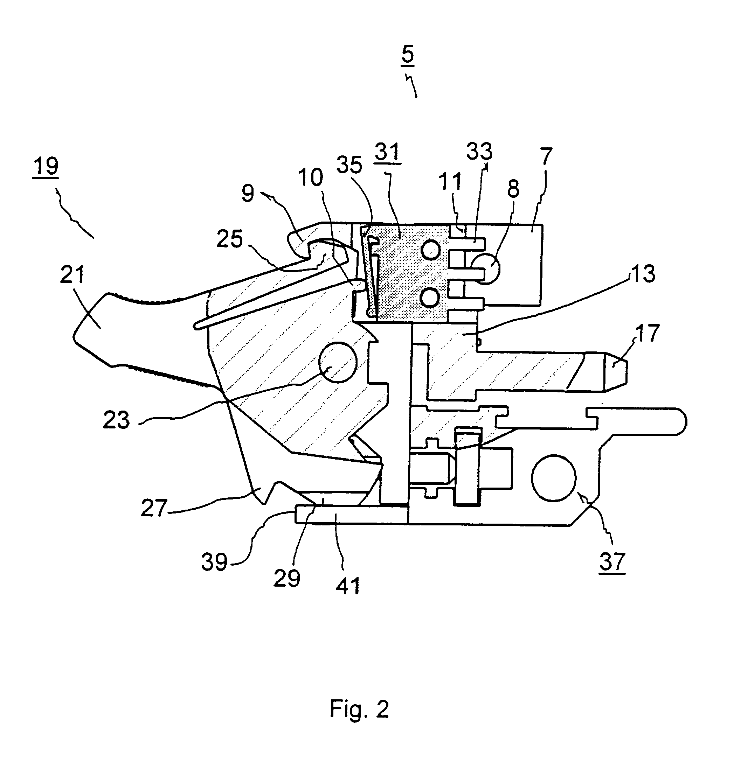

Vorteilhaft ist das integrierte Schaltelement 31 ein sogenannter Mikroschnappschalter, welcher bevorzugt über ein zusätzliches, am entsprechenden Hebelziehgriff angebrachtes Schaltstück bei Vorliegen von dessen fixierter Position betätigt wird. Figur 2 zeigt eine derartige Ausführung in Form einer Schnittdarstellung durch den Endbereich eines Frontsystems. Der Schalthebel des integrierten Mikroschnappschalters 31 wird dabei durch ein an der dem Endstück 5 zugewandten Hinterseite des Hebelziehgriffes 19 befindliches Schaltstück 10 betätigt, welches die Form eines Wulstes hat.

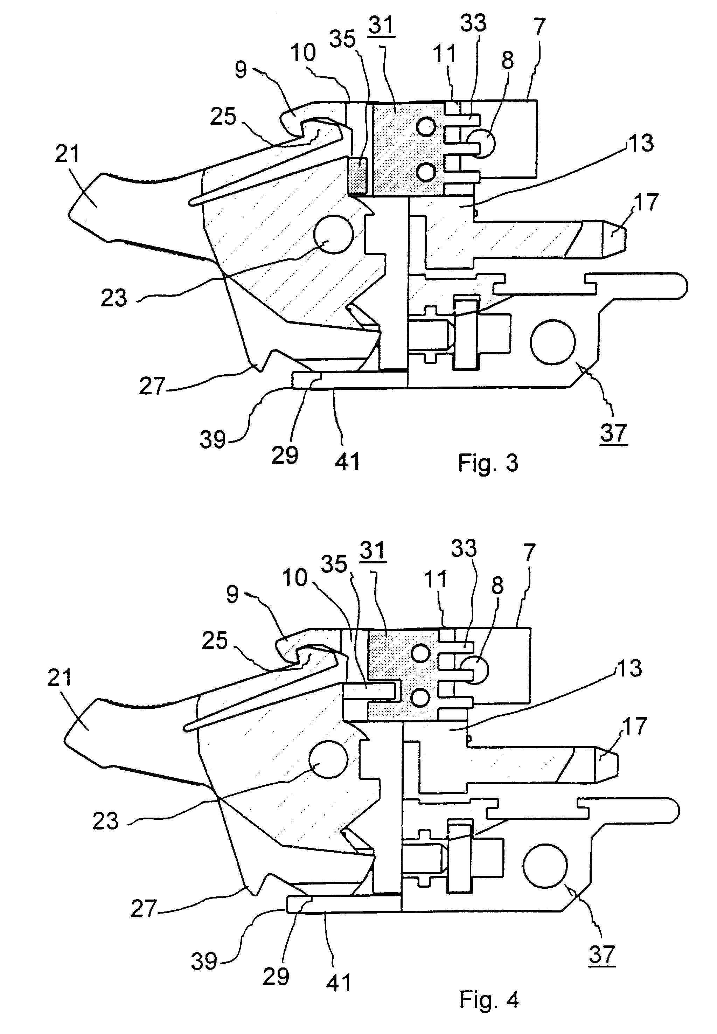

Als Schaltelemente können auch auf anderen Schaltprinzipien beruhende Bauteile gemäß der Erfindung in ein Endstück des Frontsystems einer Flachbaugruppe integriert werden. So kann als Schaltelement auch ein Halleffektsensor dienen. In Figur 3 ist ein derartiges Beispiel gezeigt, wobei in diesem Fall als Schaltstück ein an der Hinterseite des Hebelziehgriffes 19 angebrachter oder eingelassener Magnet 35 dient. Der Halleffektsensor 31 schaltet, wenn der Magnet 35 bei Erreichen der in Figur 3 dargestellten fixierten Endposition im Moment des vollständigen Einsteckens der Flachbaugruppe in den Baugruppenträger sich ausreichend angenähert hat. Eine weitere Ausführung der Erfindung ist in Figur 4 dargestellt. Dort dient als integriertes Schaltelement eine Lichtschranke 31. Ein wiederum an der Hinterseite des Hebelziehgriffes 19 angebrachtes Schaltstück 35 greift dabei in dem Moment abschattend in eine Lichtstrecke der Lichtschranke 31 ein, wenn der Hebel seine fixierte Position erreicht hat. Dies ist dann der Fall, wenn der Einhebelvorgang der Flachbaugruppe abgeschlossen und diese vollständig in den Baugruppenträger eingeschoben ist.

## Patentansprüche

1. Frontsystem einen in einen Baugruppenträger einschiebbare Flachbaugruppe (3), mit
a) je einem im oberen bzw. unteren vorderen Eckbereich der Flachbaugruppe (3) angebrachten oberen bzw. unteren Endstück (5),
b) je einem am oberen bzw. unteren Endstück (5) angebrachten oberen bzw. unteren Hebelziehgriff (19) zum Ein- und Aushebeln der Flachbaugruppe (3) in und aus dem Baugruppenträger, welche Mittel (25) aufweisen, über die der jeweilige Hebelziehgriff (19) bei Erreichen des in den Baugruppenträger eingeschobenen Zustands der Flachbaugruppe (3) in der entsprechenden Position fixiert wird, und mit
c) einem im oberen oder unteren Endstück (5) derart integrierten Schaltelement (31), daß dieses durch den entsprechenden Hebelziehgriff (19) bei Vorliegen von dessen fixierter Position betätigt wird.

2. Frontsystem nach Anspruch 1, wobei das integrierte Schaltelement (31) über eine an Anschlußkontakten (33) anbringbare Kabel- oder Kabelsteckverbindung mit der Flachbaugruppe (3) elektrisch verbindbar ist.

3. Frontsystem nach Anspruch 1 oder 2, wobei das in ein Endstück (5) integrierte Schaltelement (31) ein Mikroschnappschalter ist, welcher bevorzugt von einem Schaltstück (35) am entsprechenden Hebelziehgriff (19) bei Vorliegen von dessen fixierter Position betätigt wird (Fig.2).

4. Frontsystem nach Anspruch 1 oder 2, wobei das in ein Endstück (5) integrierte Schaltelement (31) ein Halleffektsensor ist, auf den ein am entsprechenden Hebelziehgriff (19) angebrachter Magnet (35) bei Vorliegen von dessen fixierter Position einwirkt (Fig.3).

5. Frontsystem nach Anspruch 1 oder 2, wobei das in ein Endstück (5) integrierte Schaltelement (31) eine Lichtschranke ist, auf welches ein am entsprechenden Hebelziehgriff (19) angebrachtes Schaltstück (35) bei Vorliegen von dessen fixierter Position abschattend einwirkt (Fig.3).

## Claims

1. Front system of a printed circuit board assembly (3) which can be pushed into a mounting rack, having
a) one upper and one lower end piece (5) which are fitted in the upper and lower front corner region, respectively, of the printed circuit board assembly (3),
b) one upper and one lower lever pull handle (19), which are fitted to the upper and the lower end piece (5) respectively, for levering the printed circuit board assembly (3) into and out of the mounting rack, which lever pull handles (19) have means (25) via which the respective lever pull handle (19) is fixed in the appropriate position when the printed circuit board assembly (3) has reached the point where it has been pushed into the mounting rack, and having
c) a switching element (31) which is integrated in the upper or the lower end piece (5) in such a way that the said switching element is operated by the corresponding lever pull handle (19) when it is in its fixed position.

2. Front system according to Claim 1, it being possible for the integrated switching element (31) to be electrically connected to the printed circuit board assembly (3) via a cable connection or cable plug connection which can be fitted to connecting contacts (33).

3. Front system according to Claim 1 or 2, the switching element (31) integrated in an end piece (5) being a snap-action microswitch which is preferably operated by a switching member (35) on the corresponding lever pull handle (19) when it is in its fixed position (Fig.2).

4. Front system according to Claim 1 or 2, the switching element (31) integrated in an end piece (5) being a Hall effect sensor which is acted on by a magnet (35), fitted to the corresponding lever pull handle (19), when it is in its fixed position (Fig.3).

5. Front system according to Claim 1 or 2, the switching element (31) integrated in an end piece (5) being a light barrier which is acted on in a shading manner by a switching member (35), fitted to the corresponding lever pull handle (19), when it is in its fixed position (Fig.4).

## Revendications

1. Système frontal d'un module (3) plat pouvant être enfilé dans un porte module, comportant
a) une pièce (5) d'extrémité supérieure ou inférieure montée dans la zone d'angle avant respectivement supérieure ou inférieure du module (3) plat,
b) une poignée (19) de tirage à levier supérieure ou inférieure qui est montée sur la pièce (5) d'extrémité respectivement supérieure ou inférieure, qui sert à enfiler le module (3) plat dans le porte module ou à l'en retirer et qui comporte des moyens (25) par l'intermédiaire desquels la poignée (19) de tirage à levier associée est immobilisée, lorsqu'est atteint l'état du module (3) plat dans lequel il est enfilé dans le porte module (3), en la bonne position, et comportant
c) un élément (31) de commutation intégré à la pièce (5) d'extrémité supérieure ou inférieure de telle manière que cet élément est actionné par la poignée (19) de tirage à levier correspondante lorsque cette poingée est en sa position immobilisée.

2. Système frontal suivant la revendication 1, l'élément (31) de commutation intégré pouvant être relié du point de vue électrique au module (3) plat par l'intermédiaire d'une liaison à câble ou d'une liaison à fiche de câble pouvant être montée sur des contacts (33) de raccordement.

3. Système frontal suivant la revendication 1 ou 2, l'élément (31) intégré à une pièce (5) d'extrémité étant un micro-interrupteur instantané qui est actionné, de préférence par une pièce (35) de commutation située sur la poignée (19) de tirage à levier correspondante, lorsque cette poignée est en sa position immobilisée (Fig. 2).

4. Système frontal suivant la revendication 1 ou 2, l'élément (31) de commutation intégré à une pièce (5) d'extrémité étant un détecteur à effet Hall, sur lequel un aimant (35) monté sur la poignée (19) de tirage à levier correspondante agit lorsque cette poignée est en sa position immobilisée (Fig. 3).

5. Système frontal suivant la revendication 1 ou 2, l'élément (31) de commutation intégré à une pièce (5) d'extrémité étant une cellule photoélectrlque sur laquelle agit en l'obscurcissant une pièce (35) de commutation montée sur la poignée (19) de tirage à levier correspondante lorsque cette poignée est en sa position immobilisée (Fig. 4).
